(19) Europäisches Patentamt
European Patent Office
Office européen des brevets

(11) Publication number : **0 524 754 A2**

(12) **EUROPEAN PATENT APPLICATION**

(21) Application number : **92306381.2**

(22) Date of filing : **10.07.92**

(51) Int. Cl.$^5$ : **H01L 23/532**

(30) Priority : **16.07.91 JP 201299/91**
**26.02.92 JP 75183/92**

(43) Date of publication of application :
**27.01.93 Bulletin 93/04**

(84) Designated Contracting States :
**DE FR GB**

(71) Applicant : **NEC CORPORATION**
**7-1, Shiba 5-chome Minato-ku**
**Tokyo 108-01 (JP)**

(72) Inventor : **Mitsuzuka, Tsutomu, c/o NEC Corporation**
**7-1, Shiba 5-chome**
**Minato-ku, Tokyo (JP)**
Inventor : **Kamijo, Atsushi, c/o NEC Corporation**
**7-1, Shiba 5-chome**
**Minato-ku, Tokyo (JP)**
Inventor : **Igarashi, Hitoshi, c/o NEC Corporation**
**7-1, Shiba 5-chome**
**Minato-ku, Tokyo (JP)**

(74) Representative : **Moir, Michael Christopher**
**MATHYS & SQUIRE, 10 Fleet Street**
**London EC4Y 1AY (GB)**

(54) **A film wiring and a method of its fabrication.**

(57) The object of this invention is to raise crystallizability of an Al or Al alloyed film on a base, reduce resistivity of a wiring in a super thin film area like an SAW filter, and in the wiring having film thickness not less than 5000 Å like an LSI, and to realize a film wiring having high migration resistance.

The configuration of this invention is that depositing one kind of metals such as Ti, V, Fe, Co, Ni, Cu, y of 1Å to 500Å capable of generating an intermetallic compound or an intermediate phase with Al by alloyed reaction or an alloy having these metals as constituent elements on a base 1, or simultaneously depositing Al or Al alloy with them for forming an under-coating 2, depositing an Al or Al alloyed film 3 on it, then after forming a film wiring by annealing.

The effect of this invention realizes an Al or Al alloyed film wiring of which crystallizability is improved, the resistivity is lower and the migration resistance is higher than the case of when the Al or Al-alloy film is deposited on a base.

F I G . 1

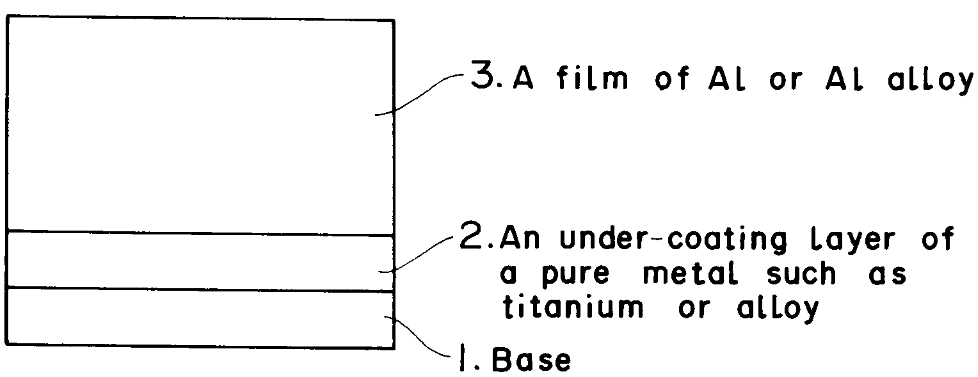


EP 0 524 754 A2

## BACKGROUND OF THE INVENTION

This invention relates to a film wiring and a method of its fabrication.

In a metallic wiring used for surface acoustic wave (SAW) devices, large scale integrated circuits (LSI) or the like, it is known to add silicon (Si) or copper (Cu) in a very small amount into aluminium (Al). Especially in a wiring of large scale integrated circuit (LSI), there is known a double layer structure having a under-coating layer of a level of 1000Å in thickness which consists of a high fusing point metal such as titanium nitride (TiN) or tungsten (W), for a purpose of increasing electron migration resistance and stress migration resistance.

The film thickness of the wiring used for SAW devices in high frequency band must be much thinner than in an LSI. For example, it is not more than 500 Å in GHz band. In the case of directly depositing Al or Al alloy on a base consisting of quartz or the like for an SAW filter, resistance of the film increases greatly with reducing film thickness. The reason for this phenomenon is that Al crystals grow like islands in the initial stage of growth of the film and the growth of the crystal grain around the core islands is insufficient when that the film thickness is thin.

On the other hand, in an LSI wiring, along with using a system of Al alloy in which Si or Cu is added in a very small amount for increasing reliability, a high fusing point metal such as TiN or the like of which film thickness is of the order of 1000 Å is used as an under-coating layer. Even in such a lamination structure, however, a reliable electron migration resistance is not achieved. See for example, p.25 of "Proceedings of 28th Reliability Physics Symposium" 1990).

Also on the other hand, it is already known about an aluminium film that the higher the orientation of (lll), the higher the migration resistance. (For example, in P.253 of " Thin Solid Films " Vol. 75, 1981) However, none of the prior art can offer a sufficiently high orientation of (lll) of aluminium. ( For example, in p.2443 of " Applied Physics Letters " Vol. 54, 1989)

## SUMMARY OF THE INVENTION

The object of the preferred embodiment of this invention is to offer an aluminium wiring and a method of its fabrication characterizing low resistivity in super thin film area of a level of 100 Å in thickness such as an SAW filter and high migration resistance for a wiring of which film thickness is not less than 5000Å such as an LSI.

In one aspect, the invention provides a film wiring comprising an under-coating layer and a film: wherein said film is formed on said under-coating layer, said under-coating layer is a metallic layer of 1 Å to 500 Å in thickness and said film consists of aluminium or an aluminium alloy.

In another aspect the invention provides a method of fabrication of a film wiring: wherein the steps of fabrication consist of depositing metal on a base and depositing Al or Al alloy on it, thereby to provide a metal under-coating of 1 Å to 500 Å in thickness under the Al or Al alloyed film.

The invention also provides a method of fabrication of a film wiring: wherein the steps of fabrication consist of simultaneously depositing metal and Al or Al alloy on a base and depositing Al or Al alloy on it, thereby to provide a metal under-coating layer of 1 Å to 500 Å in thickness under the Al or Al alloyed film.

It is desirable that the under-coating layer is comprised of metal having positive heat of formation when generating an intermetallic compound or an intermediate phase with aluminium, or alloy having the metals as constitutive elements, and it is desirable that the under-coating layer is comprised of metals capable of generating an intermetallic compound or an intermediate phase with aluminium by alloying reaction, or alloy having the metals as constitutive elements.

Both types of structures achieved by this invention are suitable, that is, a type comprising an under-coating layer including an intermetallic compound or an intermediate phase in a boundary of the upside Al or Al alloyed film in the case that the under-coating layer comprises of selected materials among Ti, V, Fe, Co, Ni, Y and an alloy having said elements as constitutive elements, and another type comprising an under-coating layer not including an intermetallic compound or an intermediate phase in a boundary of the upside Al or Al alloyed film in the case that the under-coating layer comprises of selected materials among Cu, Cr and an alloy having said elements as constitutive elements.

Also, it is desirable that an annealing process is done after making a double layer film. In this case it is desirable that the annealing temperature is in the range 100°C to 450°C, and the annealing time is not less than 10 minutes.

## DESCRIPTION OF FIGURES

The invention will be described solely by way of example with reference to the accompanying drawings, wherein

Fig. 1 illustrates a film wiring of this invention.

Fig. 2 illustrates another film wiring of this invention.

Fig. 3 shows a comparison of Al ( 111 ) X-ray diffraction intensity depending on the existence of a Ti under-coating layer.

Fig. 4 shows a comparison of Al ( III ) X-ray diffraction intensity depending on the existence of annealing.

Fig. 5 shows the annealing time dependency of film resistivity.

Fig. 6 shows the annealing temperature dependency of film resitivity with a 10Å Ti under-coating.

Fig. 7 shows the annealing temperature dependency of film resitivity with a 10Å Ti under-coating.

Fig. 8 shows the Ti under-coating film thickness dependency of resistivity be fore and after annealing.

Fig. 9 shows the Ti film thickness dependency of FWHM rocking curve before and after annealing.

Fig. 10 shows the CoAl film thickness dependency ( under-coating layer is Co : Al = 1 : 1 ) of film resistivity before and after annealing.

Fig. 11 shows the Co-Al film thickness dependency (under-coating layer is Co : Al = 1 : 1 ) of the FWHM rocking curve ($\Delta$ $\theta$) before and after annealing.

Fig. 12 shows the Co ratio in a CoAl under-coating layer dependency of film resistivity before and after annealing.

Fig. 13 shows the Co ratio in a CoAl under-coating layer dependency of the FWHM rocking curve ($\Delta$ $\theta$) before and after annealing.

Referring to Figures 1 and 2, a film wiring according to the invention comprises a base 1, an under-coating layer 2 of pure metal such as titanium or alloy (Figure 1), or and

under-coating layer 2 of the pure metal such as titanium or allly with alloyed Al (figure 2) and an Al or Al alloyed film 3.

The (III) orientation of an Al or Al alloyed film is extremely strong when deposited on an undercoating layer of 1Å to 500Å in thickness of metals of which heat of formation is positive at the time of generating an intermetallic compound or an intermediate phase with Al.

This is because it is more advantageous for aluminium crystals to grow flatly than to grow in bonding with each other like islands at the initial time of growth from the view point of energy when the under-coating layer includes a metal highly reactive with Al. Al flatly growing becomes a single axis orientated film in which the surface energy of Al is smallest and (III) of Al is orientated. This growth pattern does not change if thickness of the Al film becomes thicker.

At this time, there are two cases, that is, one case is that the under-coating metal film and the upside Al layer form an intermetallic compound or an intermediate phase in the boundary and another case does not form it. In both cases, Al is in (III) orientation. In the case of simultaneously depositing, as an under-coating layer, metals of which heat of formation is positive at the time of generating an intermetallic compound or an intermediate phase with Al, then after depositing Al on the under-coating layer, the growth pattern of Al is similar to the above pattern.

In this case, the resistance value of the wiring does not becomes bigger even used in the wiring of the super thin film required for an SAW filter in high frequency band, because island growth does not occur even in the area that the thickness of the Al film is thin. Also, migration resistance increases because orientation of (III) of Al is extremely strong.

In the case that the thickness of the under-coating metal is less than lÅ, Al grows like islands and orientation of (III) goes down, because the under-coating metal can not cover the surface of the base. In the case that the thickness of the film is over 500Å, the orientation of (III) also goes down, because irregularity appears on the surface of the under-coating layer and the orientation of the Al (III) on it also goes down. That is, the effect can appear in the range of the film thickness of the under-coating layer between lÅ and 500Å.

In the case that the metal of which heat of formation is negative or an alloy consisting of the metal and Al is the under-coating layer, the above-mentioned effect on the under-coating layer does not appear, because the reactivity with Al is low and Al grows like islands.

By annealing the double layer film of which (III) is orientated, it is possible to reduce lattice defects within the Al layer, increase the flatness of the surface,and further increase the orientation. As the result, the resistance value becomes lower and the migration resistance can be further improved than before annealing.

Next, Particular embodiments of this invention are described.

Fig.1 and Fig.2 show cross sections of a film wiring according to this invention. In Fig. 1, the metals of which heat of formation is positive when forming an intermetallic compound or an intermediate phase with Al such as titanium (Ti), chromium (Cr), vanadium (V), iron (Fe), cobalt (Co), nickel (Ni), copper (Cu), ytrium (Y) or an alloy including the metals as constituent elements are deposited as the under-coating 2 on the base 1, and the (III) oriented Al or Al alloyed film 3 (alloyed with silicon (Si) or copper (Cu)) is deposited on the under-coating layer 2.

In Fig.2, an under-coating layer 2′ consisting of an alloy of Al and metal M ( a metal of which heat of formation is positive when generating an intermetallic compound with Al or an alloy including the metals as constituent elements ) and an intermetallic compound or an intermediate phase of which heat of formation is positive are deposited on the base, and then the A1 alloyed film 3 which includes a very small amount of Al having, (111) orientation, Si or Cu is deposited on the under-coating layer 2′.

The experimental manufacture of a film using binary ion beam sputtering will now be described. The ion beam sputter application consists of two ion beam sources, a base, a target which is Al or Al alloy and a target which is the metal ( titanium in this example ) used for the under-coating layer, a shutter to open and close a sputter particle beam eroded from the two targets, a quartz resonator film thickness tester to monitor the thickness of film, an electron gun for reflection high-speed electron beam diffraction to evaluate the film surface structure made on the base and a fluorescence screen.

Evacuation is done by a cryopump through a gate valve. Argon gas is used for sputter gas. Sputtering is done at argon pressure $2X10^{-4}$ Torr after evacuation to a pressure of 1 X $10^{-7}$Torr.

Reflection high-speed electron beam diffraction (RHEED) and X-ray diffraction (XRD) of Al(lll) are done in two cases, one case is of depositing Al-0.5wt.%Cu alloy in 150 Å thickness on a titanium (Ti) under-coating layer of 10 Å in thickness and another case is of directly depositing a simple Al alloy film in 150 Å thickness.

The test sample is made on a quartz base at room temperature. It is confirmed through RHEED that an Al alloy film without a titanium under-coating layer is multicrystalline, but it with a titanium under-coating layer has (lll) orientation that [lll] crystallographic axis of Al is vertically arranged on the quartz base.

Fig.3 shows a comparison of X-ray diffraction intensity of Al (lll). As Fig.3 shows, orientation of the Al alloyed film on the titanium under-coating layer is greatly improved in compared to the case without the titanium under-coating layer. By composition analysis of the film with Auger electron spectrum, it is confirmed that Al and Ti are completely reacted each other in the part corresponding to the under-coating layer and intermetallic compound AlTi is formed.

The Al alloy film on the intermetallic compound layer has no diffusion of Ti.

In the case that the metal having high reactivity with Al is included in the under-coating layer, Al grows (lll) orientation, which produces the most dense surface . Because for Al, flatly growing through bonding of atoms is more advantageous than island-like crystal growth from the view point of energy at the initial growth. Therefore, Al does not grow like islands even in an area of super thin film such as 150Å. By this reason, film resistivity of the Al film having Ti under-coating layer becomes smaller in comparison with the case not having a Ti under-coating layer. For example, resistivity of the Al film of 150Å in thickness which is made on a quartz base without Ti under-coating layer is 4.5 $\mu\Omega \cdot$ cm, contrary to this resistivity of the Al film of same thickness to the above which is made on a quartz base with a Ti under-coating layer of 10Å in thickness is 3.8$\mu\Omega \cdot$ cm.

Next, for investigating the effect of annealing on a double layer film, the film which is made in the above example and having a structure of Al-0.5wt.%Cu(150 Å)/Ti (10 Å) is annealed for one hour at 200°C in vacuum of $1X10^{-7}$ Torr. Fig.4 shows a comparison on X-ray diffraction intensity of Al(lll) before and after annealing. This figure shows that the orientation of this Al alloy film on the titanium under-coating layer is obviously improved by annealing. Also resistivity of the double layer film is 3.8 $\mu\Omega \cdot$ cm before annealing, contrary to this it is reduced to 3.2$\mu\Omega \cdot$ cm after annealing.

Also annealing time and annealing temperature are investigated. On the Al-0.5wt.%Cu(150 Å)/Ti(10 Å) made on the quartz base, a change of resistivity is investigated under the condition in Ar atmosphere, at 200°C for annealing temperature and annealing time variation from 5 minutes to 2 hours. Fig.5 shows the result. In this case, the resistance value goes down and reaches a constant value when annealed for 10 minutes or more. Next, resistivity before and after annealing is investigated under the condition that the annealing time is one hour and the variation of annealing temperature is from 50°C to 500°C. Fig.6 shows the result.

The resistance value goes down when annealing temperature is not less than 100°C. Next, changing the thickness of Ti, an experiment in the same way to the above is done on Al-0.5wt.%Cu(150 Å)/Ti(100 Å). Fig. 7 shows the result. In this case, it is found that the under-coating Ti layer diffuse with the upside Al alloy layer and the resistivity goes up when the annealing temperature is not less than 450°C.

Next, for investigating an effect on variation of the thickness of film of the Ti under-coating layer, changing the thickness of Ti film in the range of 0.5 to 1000 Å, the film resistivity in the case of depositing the Al-0.5wt. %Cu film of 300 Å in thickness on the under-coating layer and the full width of the half maximum (FWHM) ($\Delta\theta$) of the rocking curve at the peak of Al(lll) of 300 Å, 1$\mu$m Al-0. 5wt.%Cu film are investigated, and then an electron migration test is done.

Further, for investigating an annealing effect on variation of the thickness Ti under-coating layer, an experiment is done on the above samples to find variation before and after annealing. Fig.8, Fig.9, Table-1 show the results.

Using silicon(100) with a hot oxide film for a base, the base temperature is set at 100°C. The case without a Ti under-coating layer is also tested for a comparison. The annealing temperature is 250°C and the annealing time is 2 hours.

Also, using a test pattern such as the overall length in which current flows is 2cm, the line width is 1.0μm, the line space is 2.0μm, an electron migration test is performed. Under the condition that the temperature is 250°C, the current density is $2.0X10^6A/cm^{-2}$, investigating the time until 50% of 100 pieces of samples are broken.

[Table-1]

| Layer of Ti Film Thickness (Å) | Thickness of Al-0.5%Cu Film (Å) 300Å | | 1μm | |
|---|---|---|---|---|
| | Before Annealing | After Annealing | Before Annealing | After Annealing |
| 0 | 1.5 | 1.5 | 50 | 50 |
| 0.5 | 1.5 | 1.5 | 50 | 50 |
| 1 | 30 | 60 | 200 | 400 |
| 5 | 80 | 170 | 350 | 800 |
| 10 | 100 | 210 | 400 | 850 |
| 20 | 100 | 220 | 500 | 1000 |
| 50 | 100 | 220 | 500 | 1000 |
| 100 | 95 | 200 | 400 | 850 |
| 200 | 85 | 190 | 380 | 800 |
| 500 | 80 | 180 | 360 | 780 |
| 700 | 1.4 | 1.4 | 50 | 50 |
| 1000 | 1.4 | 1.4 | 48 | 48 |

Hours

The above results show that the resistivity of the 300 A thickness film reduces considerably when the film thickness of the titanium under-coating layer is in the range of 1 Å to 500 Å, and although generally the thicker the film is, the higher the orientation of Al (III) is and the larger the electron migration resistance is, the orientation of Al (III) becomes much higher and the electron migration resistance becomes much larger in both cases of 300 Å and 1μm in comparison with lack of an under-coating layer when the film thickness of the titanium under-coating layer is in the range of 1 Å to 500 Å.

Also it is found that a reduction of resistance and an improvement of reliability remarkably appear by annealing when film thickness of the titanium under-coating layer is in the range of 1 Å to 500 Å.

Also it is found that the orientation of the A1 (III) becomes extremely high and the electron migration resistance becomes extremely large when the film thickness of the titanium under-coating layer is in the range of 1 Å to 500 Å even in both cases that the thickness of the Al alloy layer is 300 Å and 1μm in comparison with non-annealing.

In the above-mentioned embodiment it is found that titanium and Al used for the under-coating layer react each other, and an intermetallic compound of the stable composition ratio of AlTi is formed, and an Al or Al alloyed film deposited on it grows flatly, and a high orientation film is formed on it. Next there is considered the case of choosing metals which react with Al and form an intermetallic compound or an intermediate phase and an alloy including them as constituent elements for an under-coating layer.

In this embodiment a vacuum evaporator capable of forming film with a small amount of ingot is used as various kinds of metals for under-coating must be tested. The vacuum evaporator used in this example consists of an electron beam evaporation source in which Al ( or Al alloy ) and metal for the under-coating layer are placed, a shutter to open and close the molecular beam from two deposition sources, a quartz resonator film thickness tester to monitor the film thickness, an electron gun for reflection high-speed electron beam diffraction to evaluate the film surface structure formed on the base, and a fluorescence screen.

The deposition is performed after evacuating through a gate valve to $1X10^{-7}$Torr with a turbo molecular pump. The degree of vacuum is 1 to $8X10^{-6}$Torr at the time of deposition.

After depositing eight kinds of metals such as vanadium (V), iron (Fe), cobalt (Co), nickel (Ni), copper (Cu), ytrium (Y), chromium (Cr), zinc (Zn) and three kinds of alloys such as $Fe_{20}Ni_{80}$ (Fe20%,Ni80% alloy), $Ti_{50}V_{50}$ and $Co_{90}Ni_{10}$ on the $LiNbO_3$ base ( the base temperature is room temperature ) at the film thickness of 10Å, Al is deposited 300 Å in thickness on this under-coating layer.

The composition of the intermetallic compound or the intermediate phase in the under-coating film and its generating energy values in documents derived from the film resistivity, the FWHM (Δ θ) of Al(lll) rocking curve, the electron migration resistance ( the above-mentioned time until 50% of samples fail ) and the Auger electron spectrum are shown in table-2.

For comparison, the results without under-coating metal film is also shown in table-2.

[ Table-2 ]

E.M.R.:Electro-Migration Resistance

A:Composition of intermetallic Compound or Intermediate Phase

B:Generation Energy of intermetallic Compound or Intermediate Phase

| | Resistivity (μΩ · cm) | Δθ (deg) | E.M.R. (hours) | A | B |
|---|---|---|---|---|---|
| Zn | 4.0 | 4.0 | 1.5 | — | — |
| V | 3.5 | 2.3 | 110 | $Al_3V$ | 27.6(1) |
| Fe | 3.5 | 2.2 | 100 | AlFe | 28.3(1) |
| Co | 3.4 | 2.1 | 100 | AlCo | 55.2(1) |

| | | | | | |
|---|---|---|---|---|---|
| Ni | 3.6 | 2.2 | 120 | AlNi | 59.2(1) |
| Cu | 3.5 | 2.1 | 150 | — | 20.0(1) |
| Y | 3.4 | 2.3 | 100 | $Al_3Y$ | 190.7(2) |
| Cr | 3.6 | 2.2 | 90 | — | 10.9(1) |
| $Fe_{20}Ni_{80}$ | 3.5 | 2.2 | 100 | AlFe+AlNi | — |
| $Ti_{50}V_{50}$ | 3.5 | 2.1 | 110 | $Al_3V$+AlTi | — |
| $Co_{90}Ni_{10}$ | 3.6 | 2.3 | 110 | AlCo+AlNi | — |
| Non-Under coating Layer | 4.0 | 4.0 | 1.5 | — | — |

(1) Smithelles Metals Reference Book 6th Edition Table 8.5a, 8.5c

(2) Izv. Vyssh. Uchebn, Zaved., Tsvètn. Métall. 1979, (5) 40

As obviously shown in table-2, vanadium, iron, cobalt, nickel, copper, ytrium, chromium and alloys including them as constituent elements are metals of which heat of formation of an intermetallic compound or an intermediate phase with Al is positive, and it is found that an Al film of which resistivity is low, the Al(lll) orientation is extremely good and the electron migration resistance is excellent is obtained when the metals or alloys including them as constituent elements are used for the under-coating layer.

In addition, it is not necessary to generate an intermetallic compound or an intermediate phase between the under-coating layer and the Al layer. In the case of a Cu under-coating layer or a Cr under-coating layer, although no intermetallic compound or intermediate phase is formed, yet the advantageous effect of the under-coating layer is obtained.

Contrary to this, the heat of formation of an intermetallic compound or an intermediate phase of zinc with Al is not positive. Therefore, inter Al crystals grow like advantageous from the view point of energy, and Al crystals grow like island at the time of initial growth. For this reason, a reduction of resistivity, an improvement of Al(lll) orientation, an improvement of electron migration resistance as shown in the cases of titanium, cobalt, ytrium are not observed regardless of the film thickness of the zinc under-coating layer.

Next, for investigating the annealing effects on the samples, annealing is done for one hour at 300°C in nitrogen atmosphere after making the samples. And then, the film resistivity, the FWHM ($\Delta\ \theta$) of Al(lll) rocking curve, the electron migration resistance ( the above-mentioned time until 50% of samples fail ) before and after annealing are investigated. The results are shown in Table-3.

B.A.: Before Annealing A.A.: After Annealing

| | Resistivity ($\mu\Omega \cdot cm$) | | $\Delta\theta$ (deg) | | Electro-migration Resistance (hours) | |
|---|---|---|---|---|---|---|
| | B.A. | A.A. | B.A. | A.A. | B.A. | A.A. |
| Zn | 4.0 | 4.0 | 4.0 | 4.0 | 1.5 | 1.5 |
| V | 3.5 | 3.0 | 2.3 | 1.8 | 110 | 200 |
| Fe | 3.5 | 2.9 | 2.2 | 1.8 | 100 | 190 |
| Co | 3.4 | 3.1 | 2.1 | 1.7 | 100 | 210 |
| Ni | 3.6 | 3.0 | 2.2 | 1.8 | 120 | 200 |
| Cu | 3.5 | 2.9 | 2.1 | 1.7 | 150 | 200 |
| Y | 3.4 | 3.0 | 2.3 | 1.8 | 100 | 210 |
| Cr | 3.6 | 3.1 | 2.2 | 1.7 | 90 | 200 |
| $Fe_{20}Ni_{80}$ | 3.5 | 3.0 | 2.2 | 1.8 | 100 | 200 |
| $Ti_{50}V_{50}$ | 3.5 | 2.9 | 2.1 | 1.8 | 110 | 210 |
| $Co_{30}Ni_{10}$ | 3.6 | 3.0 | 2.3 | 1.7 | 110 | 200 |
| Non-under coating Layer | 4.0 | 4.0 | 4.0 | 4.0 | 1.5 | 1.5 |

As for the samples in which the benefits of the under-coating layer are obtained from the above results it is found that these are a reduction of resistivity by annealing, an improvement of (III) orientation and an improvement of electron migration resistance.

A further experiment was performed to investigate the effects of variations in film thickness of the under-coating layer in between 0.5Å to 1000Å with eight kinds of metal under-coatings such as vanadium (V), iron (Fe), cobalt (Co), nickel (Ni), copper (Cu), ytrium (Y), chromium (Cr), zinc (Zn) and three kinds of alloys such as $Fe_{20}Ni_{80}$ (Fe20%,Ni80% alloy), $Ti_{50}V_{50}$, $Co_{90}Ni_{10}$.

The effects such as a reduction of resistivity, an improvement of Al (III) orientation, an improvement of electron migration resistance and the range of the film thickness of the under-coating layer where the effects by annealing appears are constant from 1 Å to 500 Å in film thickness regardless of the kinds of metal used for the under-coating layer. However, the cases of Cu and Cr are exceptional. On Cu in the range from 1 Å to 30 A in film thickness, on Cr from 1 Å to 50 Å, the effects appear. In the case of using Zn as the under-coating layer, the benefits of an under-coating layer do not appear in any range of film thickness.

In the above example , each simple metal M or alloy of them are used for the under-coating layer. Next, the case of simultaneously depositing each metal M or alloy and Al for the under-coating layer is described. Also the use of a binary magnetron sputter for forming a film and changing the composition ratio of aluminium and cobalt in an under-coating metal layer from 0 : 100 to 100 : 0 is explained.

The magnetron sputter used in the experiments consists of a target of Al-2.0wt.%Si alloy and Co which are respectively put on a magnet, a base, a shutter provided between a base and a target, a quartz resonator film thickness tester to monitor film thickness. Evacuation is done with a cryopump through a gate valve. Argon gas is used as sputter gas.

After evacuating to 1 X $10^{-7}$Torr, sputtering is done at 3 to 7mTorr in argon pressure. Arranging the power of two sputter guns to set the composition ratio of cobalt and aluminium from 0 : 100 to 100 : 0 by atomic weight %( at%), Al alloy of thickness 0.5 Å to 1000 Å is formed on a glass base at base temperature 300°C. And then, annealing is done for 30 minutes at 200°C in vacuum 1 X $10^{-4}$Torr.

At first, fixing the ratio of cobalt and aluminium 1 : 1, the following tests are performed. The results of the test of film resistivity of Al-2.0wt%Si of film thickness 300 Å in variation from 0.5 Å to 1000 Å of the thickness of this Co-Al alloyed under-coating layer, and the results of the tests on the FWHM ($\Delta\theta$) of rocking curve and electron migration on the peak of Al (lll) before and after annealing in the cases of 300 Å, 1μm are respectively shown in Fig.10, Fig.11, table-4.

For comparison, the cases without an AlCo intermetallic compound under-coating layer are also investigated. The overall length of the test pattern where current flows is 2cm, the line width is 1.0μm and the inter line space is 2.0μm is used for an electron migration test. Using 100 pieces of samples and under the condition of current density 2.0X$10^6$A/$cm^{-2}$ and temperature 250°C, the time until 50% of samples fail is investigated.

[ Tables-4 ]

| Layer of Co-Al Film Thickness (Å) | Thickness of Al-2.0wt%Si Film (Å) 300Å Before Annealing | 300Å After Annealing | 1μm Before Annealing | 1μm After Annealing |
|---|---|---|---|---|
| 0 | 1.5 | 1.5 | 50 | 50 |
| 0.5 | 1.5 | 1.5 | 50 | 50 |
| 1 | 30 | 65 | 220 | 400 |
| 5 | 80 | 170 | 350 | 800 |
| 10 | 100 | 210 | 400 | 850 |
| 20 | 100 | 210 | 500 | 900 |
| 30 | 100 | 200 | 500 | 900 |
| 50 | 100 | 200 | 500 | 850 |
| 200 | 100 | 190 | 500 | 800 |
| 500 | 90 | 160 | 450 | 770 |
| 700 | 1.5 | 1.5 | 50 | 50 |
| 1000 | 1.4 | 1.4 | 48 | 48 |

Hours

From the results, it can be seen that the film resistivity of the 300Å film is extremely low when the film thickness of CoAl intermetallic compound under-coating layer is in the range of 1Å to 500Å, and the Al (lll) orientation is extremely high and the electron migration resistance is extremely large in comparison with the case of,no under-coating layer in both cases of 300Å and 1 μm film thickness when the CoAl intermetallic compound under-coating layer is in the range of 5Å to 100 Å.

Next, fixing the thickness of the Co-Al alloy undercoating layer at 20Å and changing the ratio of cobalt and aluminium from 0 : 100 to 100 : 0 at%, the same tests are performed. The results are shown in Fig.12, Fig.13 and table-5. For comparison, the case without an Al-Co alloy under-coat ing layer are also investigated. The overall length of the test pattern where current flows is 2cm, the line width is 1.0μm and the inter line space is 2.0μm is used for the electron migration test. Using 100 pieces of samples and under the condition of current

density 2.0X $10^6$A/$cm^{-2}$ and temperature 250°C, the time until 50% of samples fail is investigated.

[ Table-5 ]

| Ratio of Co in the Layer of | Thickness of Al-0.5%Cu Film (Å) | | | |
|---|---|---|---|---|
| | 300Å | | 1μm | |
| $Co_xAl_{1-x}$ (at%) | Before Annealing | After Annealing | Before Annealing | After Annealing |
| 0 | 1.5 | 1.5 | 50 | 50 |
| 1 | 1.5 | 1.5 | 50 | 50 |
| 2 | 90 | 200 | 450 | 800 |
| 10 | 100 | 210 | 470 | 850 |
| 20 | 100 | 210 | 480 | 900 |
| 40 | 100 | 210 | 480 | 900 |
| 60 | 100 | 220 | 490 | 900 |
| 80 | 100 | 220 | 500 | 950 |
| 100 | 100 | 220 | 500 | 1000 |

Hours

Through the results, it is found that the film resistivity of the 300Å film becomes low upon annealing when the film thickness of the Co-Al alloyed under-coating layer is in the range of 1Å to 500Å, and Al (lll) orientation is extremely high and the electron migration resistance is extremely large in comparison with non-annealing in both cases of 300Å and lμm film thickness, when the thickness of the CoAl under-coating layer is in the range of 1Å to 500Å. Also, it is sufficient that the amount of contents of Co in the Co-Al alloy under-coating layer is not less than 2% by at %.

In the above examples , the under-coating layer in which Al alloy and Co are simultaneously deposited is used. However, in the case of simultaneously depositing ytrium (Y), titanium (Ti), vanadium (V), chromium (Cr), iron (Fe), cobalt (Co), nickel (Ni), copper (Cu), palladium (Pd), silver (Ag), platinum (Pt), gold (Au) besides Co or alloy including them as constituent elements and Al or Al alloy for the under-coating layer that is alloy of which Al amount of contents is not more than 98at%, the completely same effects can be observed.

However, in the case of simultaneously sputtering zinc and Al or Al alloy for the under-coating layer, the effects such as a reduction of resistivity, an improvement of Al (lll) orientation are not observed at all. Also, in the above examples quartz, silicon thermal oxide, $LiNbO_3$, and glass base are described. In addition, the same effects are observed on other bases such as $LiTaO_3$, ZnO, Si, GaAs.

As described in the above examples , by this invention, crystalline orientation of the Al or Al alloy wiring is remarkably improved, the electrical specifications and the migration resistance is greatly improved. In surface acoustic wave device, especially a filter for high frequency band, the producing percentage is improved because losses can be decreased by reducing wiring resistance effects.

Moveover, when this invention is used for wiring of an LSI or the like, reliability against electron migration or the like is increased. The effect similarly appears in either cases of depositing an Al alloyed film after depositing a metal film or simultaneously depositing both elements.

## Claims

1. A film wiring comprising an under-coating layer and a film: wherein said film is formed on said under-coating layer, said under-coating layer is a metallic layer of 1 Å to 500 Å in thickness and said film consists of aluminium or an aluminium alloy.

2. A film wiring, as set forth in Claim 1: wherein said under-coating layer comprises a metal having positive heat of formation when generating an intermetallic compound or an intermediate phase with aluminium, or an alloy having said metals as constitutive elements.

3. A film wiring, as set forth in Claim 1: wherein said under-coating layer comprises a metal capable of generating an intermetallic compound or an intermediate phase with aluminium by alloying reaction, or an alloy having said metals as constitutive elements.

4. A film wiring, as set forth in Claim 1: wherein said under-coating layer includes an intermetallic compound or an intermediate phase in a boundary of the Al or Al alloyed film.

5. A film wiring, as set forth in any preceding Claim: wherein said under-coating layer comprises a metal selected from among Ti, V, Fe, Co, Ni, Y a an alloy having constituents selected from amongst those metals.

6. A film wiring, as set forth in Claim 1: wherein said under-coating layer does not include an intermetallic compound or an intermediate phase in a boundary of the Al or Al alloyed film.

7. A film wiring, as set forth in Claim 1, Claim 2 or Claim 6: wherein said under-coating layer comprises Cu,Cr or a Cu-Cr alloy.

8. A method of fabrication of a film wiring: wherein the steps of fabrication consist of depositing metal on a base and depositing Al or Al alloy on it, thereby to provide a metal under-coating layer of 1Å to 500Å in thickness under the Al or Al alloyed film.

9. A method of fabrication of a film wiring: wherein the steps of fabrication consist of simultaneously depositing metal and Al or Al alloy on a base and depositing Al or Al alloy on it, thereby to provide a metal under-coating layer to 1Å to 500Å in thickness under the Al alloyed film.

10. A method of fabrication of a film wiring, as set forth in Claim 8 or Claim 9: comprising providing as said under-coating layer a metal having positive heat of formation when generating an intermetallic compound or an intermediate phase with aluminium, or alloy having such metals as constitutive elements.

11. A method of fabrication of a fim wiring, as set forth in Claim 8 or Claim 9: comprising providing in said under-coating layer a metal capable of generating an intermetallic compound or an intermediate phase with aluminium by alloying reaction, or alloy having such metals as constitutive elements.

12. A method of fabrication of a film wiring, as set forth in Claim 8 or Claim 9: comprising providing in said under-coating layer an intermetallic compound or an intermediate phase at a boundary of the Al or Al alloyed film.

13. A method of fabrication of a film wiring, as set forth in Claim 8 or Claim 9: comprising providing in said under-coating layer a metal selected from among Ti, V, Fe, Co, Ni, Y or an alloy having constituents selected from among those metals.

14. A method of fabrication of a film wiring, as set forth in Claim 8 or Claim 9: comprising said under-coating layer without an intermetallic compound or an intermediate phase at a boundary of the Al or Al alloyed film.

15. A method of fabrication of a film wiring, as set forth in Claim 8 or Claim 9: wherein said under-coating layer comprises Cu, Cr or a Cu-Cr alloy.

16. A method of fabrication of a film wiring, as set forth in Claim 8 or Claim 9, comprising a step of annealing after said fabrication steps.

**17.** A method of fabrication of a film wiring, as set forth in Claim 16, wherein the annealing temperature is in the range 100°C to 450°C.

**18.** A method of fabrication of a film wiring, as set forth in Claim 16 or 17, wherein the annealing time is not less than 10 minutes.

F I G . I

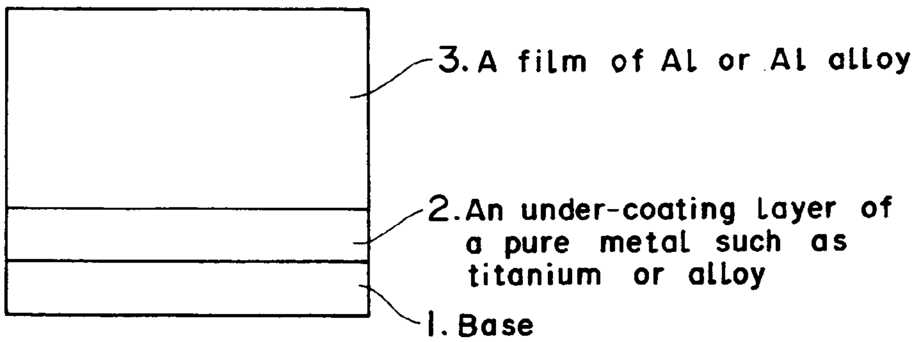
3. A film of Al or Al alloy
2. An under-coating Layer of a pure metal such as titanium or alloy
1. Base

F I G . 2

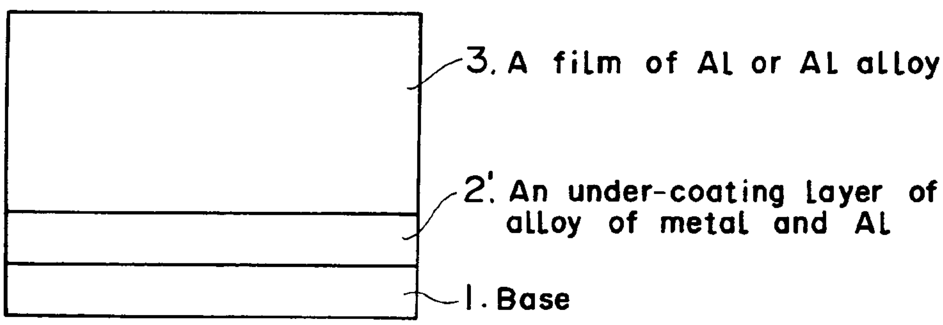
3. A film of Al or Al alloy
2'. An under-coating Layer of alloy of metal and Al
1. Base

FIG. 3

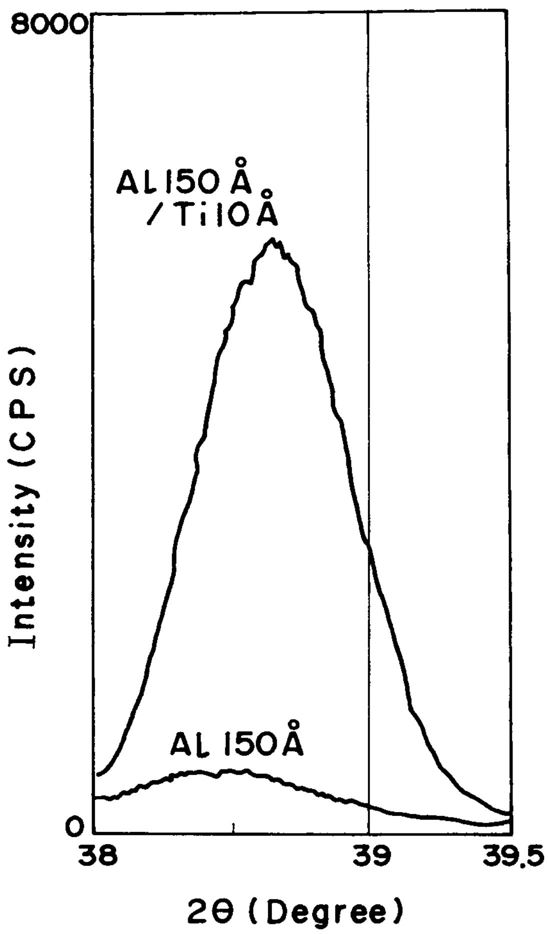

FIG. 4

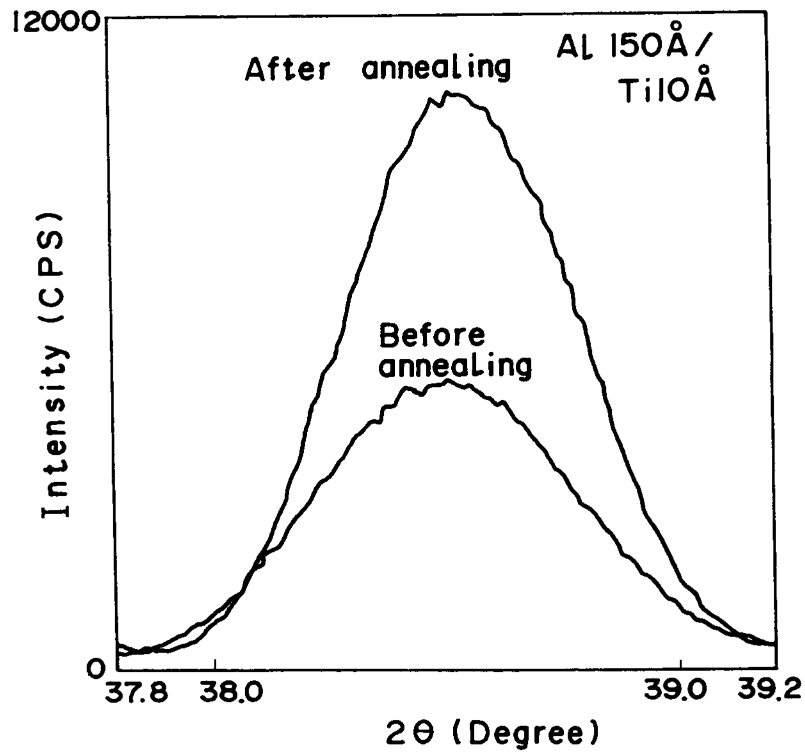
12000
0
Intensity (CPS)
After annealing
AL 150Å/
Ti10Å
Before
annealing
37.8
38.0
39.0
39.2
2θ (Degree)

FIG. 5

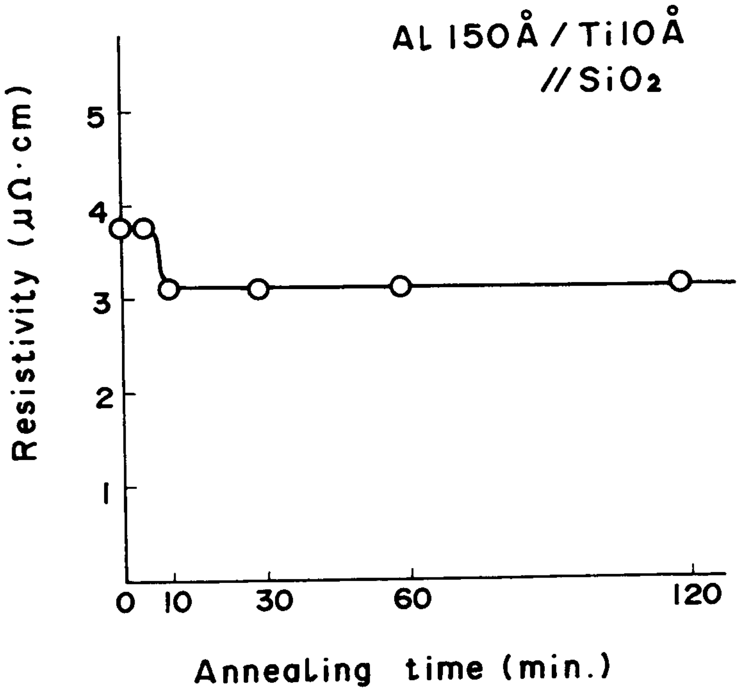
AL 150Å / Ti10Å
//SiO2
Resistivity (μΩ·cm)
5
4
3
2
1
0
10
30
60
120
Annealing time (min.)

FIG. 6

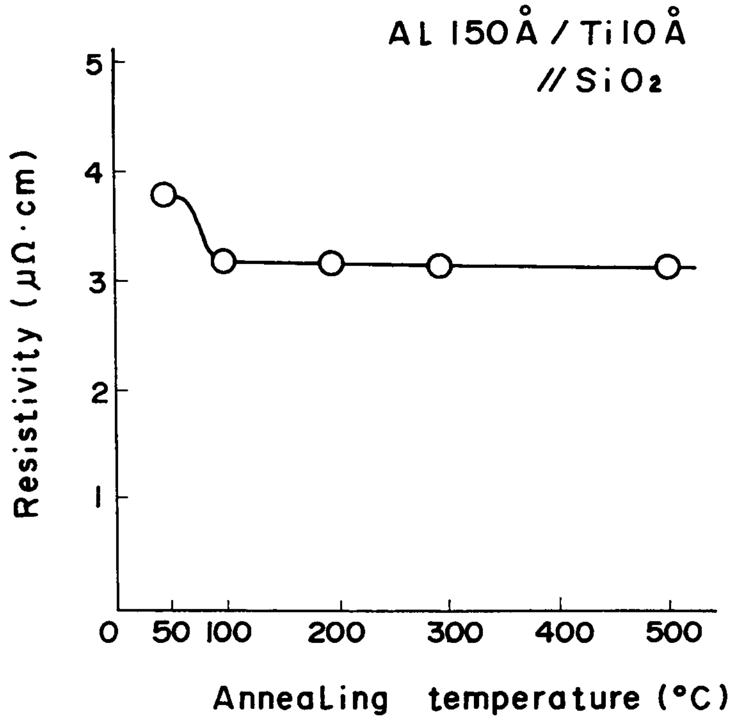
AL 150Å / Ti10Å
// SiO2
Resistivity (μΩ·cm)
5
4
3
2
1
0
50
100
200
300
400
500
Annealing temperature (°C)

FIG. 7

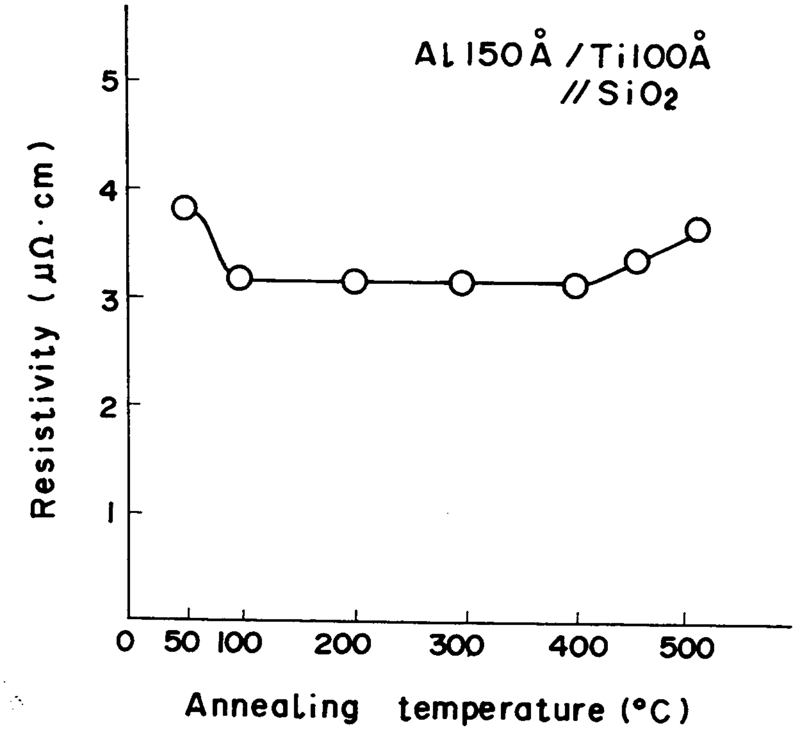
AL150Å / Ti100Å
// SiO2
Resistivity (μΩ·cm)
5
4
3
2
1
0
50
100
200
300
400
500
Annealing temperature (°C)

FIG. 8

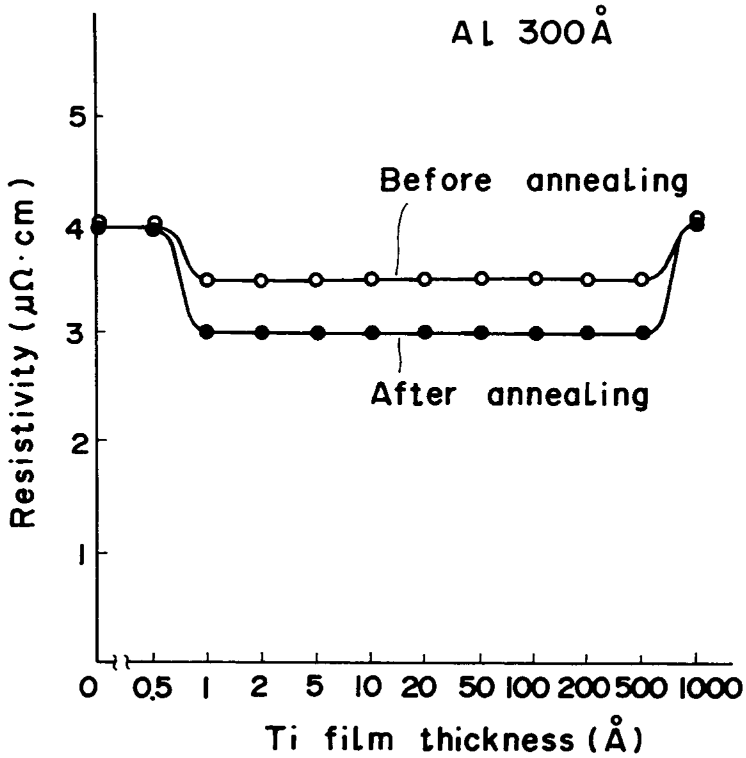
AL 300Å
Before annealing
After annealing
Resistivity (μΩ·cm)
1
2
3
4
5
0 0.5 1 2 5 10 20 50 100 200 500 1000
Ti film thickness (Å)

FIG. 9

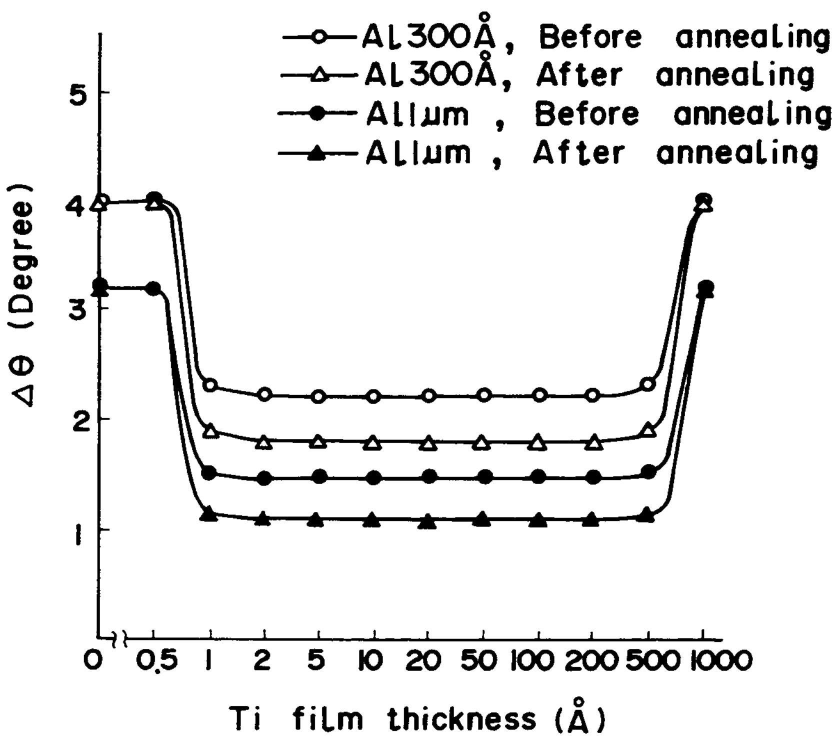
AL300Å, Before annealing
AL300Å, After annealing
AL1μm , Before annealing
AL1μm , After annealing
ΔΘ (Degree)
1
2
3
4
5
0 0.5 1 2 5 10 20 50 100 200 500 1000
Ti film thickness (Å)

FIG.10

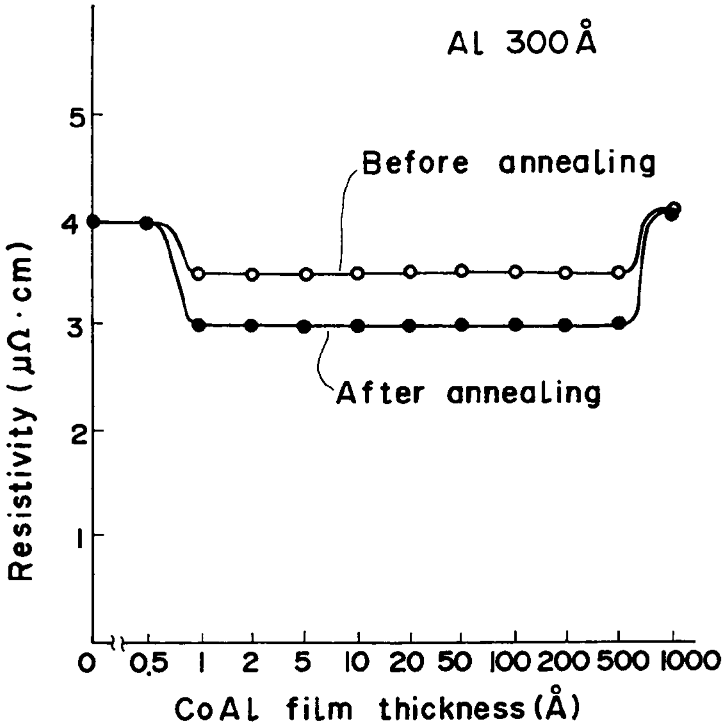
AL 300Å
Before annealing
After annealing
Resistivity (μΩ·cm)
5
4
3
2
1
0
0.5
1
2
5
10
20
50
100
200
500
1000
CoAL film thickness (Å)

FIG.11

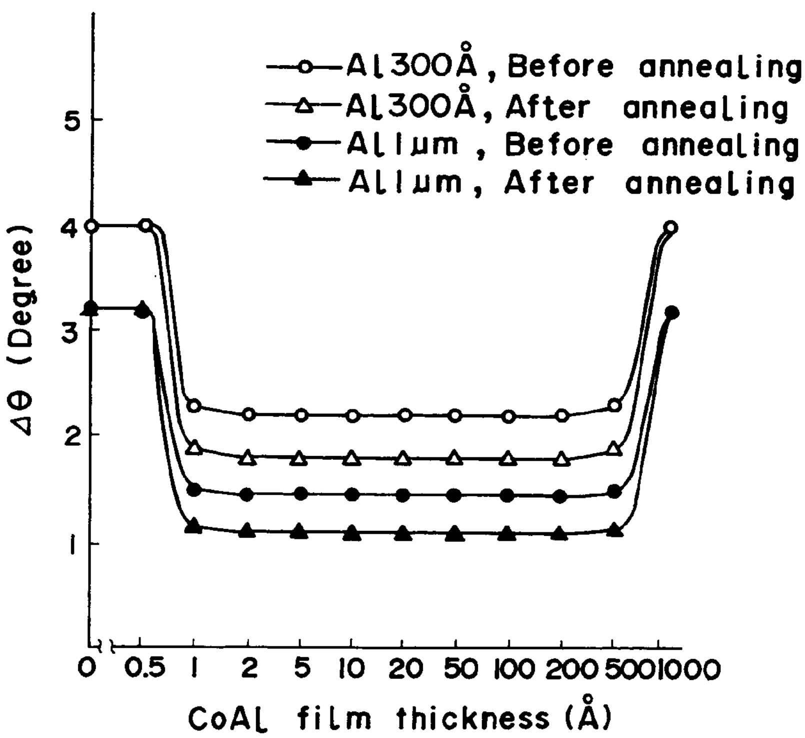
AL300Å, Before annealing
AL300Å, After annealing
AL1μm, Before annealing
AL1μm, After annealing
Δθ (Degree)
5
4
3
2
1
0
0.5
1
2
5
10
20
50
100
200
500
1000
CoAL film thickness (Å)

FIG. 12

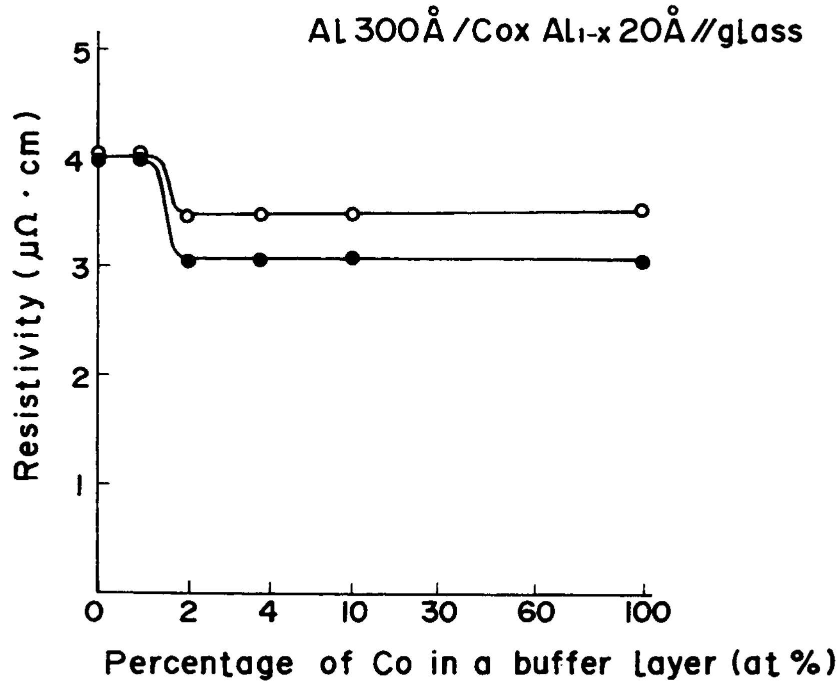
Al 300Å / Cox Al1-x 20Å // glass
5
4
3
2
1
Resistivity (μΩ · cm)
0
2
4
10
30
60
100
Percentage of Co in a buffer layer (at%)

FIG. 13

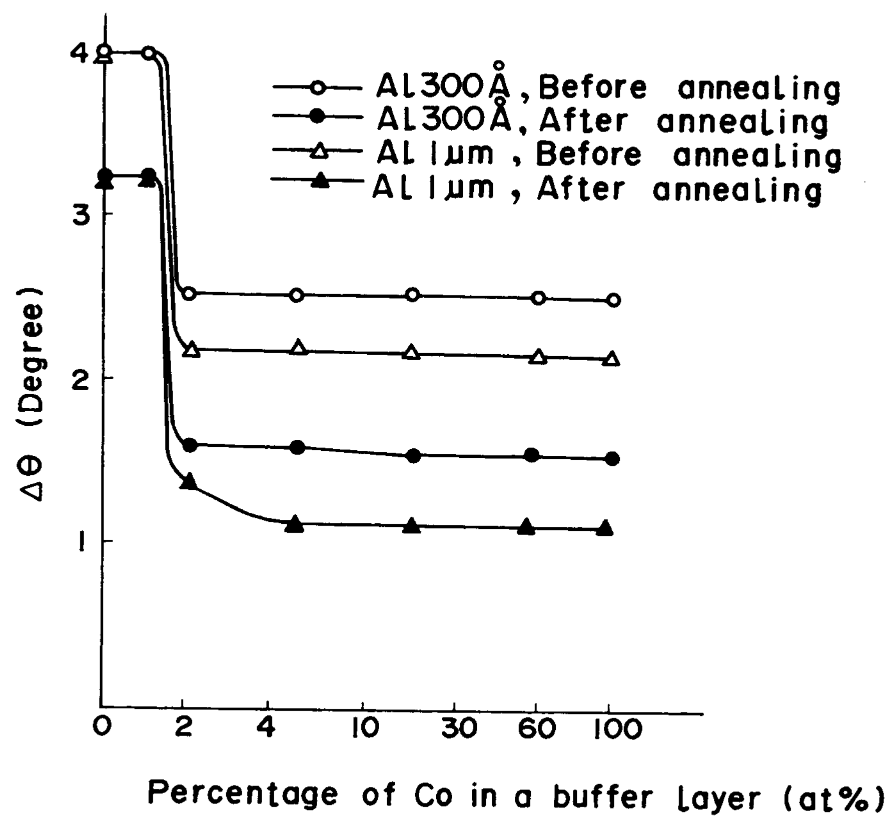
Al 300Å, Before annealing
Al 300Å, After annealing
Al 1μm, Before annealing
Al 1μm, After annealing
4
3
2
1
Δθ (Degree)
0
2
4
10
30
60
100
Percentage of Co in a buffer layer (at%)